# EUROPÄISCHE PATENTANMELDUNG

(11) **EP 1 253 306 A2**
(43) Veröffentlichungstag der Anmeldung: **30.10.2002**
(21) Anmeldenummer: 02008449.7
(22) Anmeldetag: 13.04.2002
(51) Int. Cl.: F02B 75/06, F02B 75/00

(54) **Verfahren zur Synchronisation einer Verbrennungskraftmaschine anhand der Winkellage eines rotierenden Teils**

(30) Priorität: 27.04.2001 DE 10120799
(71) Anmelder: ROBERT BOSCH GMBH, 70442 Stuttgart (DE)
(72) Erfinder: Zimmermann, Klaus, 1030 Wien (AT); Hasslacher, Oliver, 71229 Leonberg (DE); Wolf, Bodo, 74321 Bietigheim-Bissingen (DE)

(57) **Zusammenfassung**

Die Erfindung bezieht sich auf ein Verfahren zur Drehlagebestimmung einer Verbrennungskraftmaschine mit einer Nockenwelle, der ein Nockenwellensensor zugeordnet ist, mit einer Kurbelwelle, der ein Kurbelwellendrehlagegeber zugeordnet ist. Ein Steuergerät zur Steuerung der Verbrennungskraftmaschine umfaßt zumindest einen konfigurierbaren Steuergeräteeingang. Nach Erkennung einer Fehlfunktion des Kurbelwellendrehlagegebers wird der Steuergeräteeingang des Steuergerätes auf die Auswertung einer der Flanken (9.1, 10.1, 11.1, 12.1; 9.2, 10.2, 11.2, 12.2) oder aller Flanken (9.1, 10.1, 11.1, 12.1; 9.2, 10.2, 11.2, 12.2) von Impulssegmenten (A, C, E, G) geschaltet. Danach erfolgt ein Einspritzen von Kraftstoff in die Zylinder einer Verbrennungskraftmaschine bis ein Drehzahlgradient erkannt wird, der eine Positionsbestimmung der Drehlage der Kurbelwelle der Verbrennungskraftmaschine ermöglicht. Nach der Positionsbestimmung der Verbrennungskraftmaschine wird durch Auswertung aller Segmentzeiten (A, B, C, D, E, F, G, H) die Motordynamik ermittelt sowie Einspritzzeitpunkt und die Dauer von Einspritzvorgängen ermittelt, eingestellt und korrigiert.

## Beschreibung

### Technisches Gebiet

Um ein Liegenbleiben eines Kraftfahrzeuges zu vermeiden, werden an Steuergeräten von modernen Verbrennungskraftmaschinen Notbetriebsroutinen implementiert, so daß bei Ausfall eines Gebers, der eine Drehbewegung eines rotierenden Bauteiles erfaßt, ein Notbetrieb der Steuerung aufrechterhalten werden kann, um die Fahrt fortsetzen zu können. An Verbrennungskraftmaschinen werden heute Drehzahlgeber, Bezugssignalgeber sowie Phasensignalgeber eingesetzt.

### Stand der Technik

DE 33 07 833 A1 betrifft ein Verfahren zur Auslösung von zur Winkellage eines rotierenden Teiles abhängigen Vorgängen. Es wird eine Vorrichtung zum Anzeigen und/oder Speichern von Fehlern von Geberradanordnungen an Brennkraftmaschinen offenbart. Als Komponenten sind in der Geberanordnung ein Drehzahlgeber, ein Bezugsmarkengeber und ein Phasensignalgeber enthalten. Während des Betriebs der Brennkraftmaschine wird die Geberanordnung überprüft. Bei einer Abweichung von der vorgeschriebenen Reihenfolge und/oder vorgeschriebenen Abständen der Gebersignale wird ein Fehlersignal erzeugt, welches gespeichert und/oder einer Anzeigevorrichtung zugeführt wird.

DE 43 13 331 A1 betrifft ein Verfahren zur Auslösung von zur Winkellage eines rotierenden Teiles abhängigen Vorgängen. Dabei handelt es sich insbesondere um Zündungs- und Einspritzvorgänge bei einer Brennkraftmaschine. Das rotierende Teil weist über seinen Umfang verteilt Winkelmarken auf. Zur Erfassung der Winkellage des rotierenden Teils wird ein erster Geber verwendet, der bei Umlauf einer Winkelmarke ein Winkelmarkensignal abgibt. Die Winkelmarkensignale werden von ersten Zählern gezählt, wobei in Abhängigkeit des Zählergebnisses die Vorgänge ausgelöst werden und das ordnungsgemäße Auftreten von Winkelmarkensignalen überprüft wird. Ferner ist ein zweiter Geber vorgesehen, dessen Signale in einer festen Zuordnung zu den Winkelmarkensignalen des ersten Gebers stehen. Zum zweiten Zählmittel zählen die Zeittaktsignale eines Taktgenerators. Nach Erkennung des nicht ordnungsgemäßen Auftretens von Winkelmarkensignalen wird ein Notlauf gestartet, in welchem aus der zeitlichen Abfolge der Signale des zweiten Gebers mindestens ein erster Wert und ein zweiter Wert berechnet werden. Der Zählerstand der zweiten Zählmittel wird mit dem ersten und einem zweiten Wert verglichen und bei Übereinstimmung des Zählerstandes der zweiten Zählmittel mit dem mindestens einen ersten Wert einer ersten Flanke und bei Übereinstimmung des Zählerstandes des zweiten Zählmittels mit den mindestens einen zweiten Wert wird eine zweite der ersten entgegengesetzten Flanke zur Simulation mindestens eines Winkelmarkensignales erzeugt. Das mindestens eine simulierte Winkelmarkensignal wird den ersten Zählmitteln wieder zugeführt.

### Darstellung der Erfindung

Mit dem erfindungsgemäß vorgeschlagenen Verfahren läßt sich eine Positionsbestimmung einer Verbrennungskraftmaschine anhand der Information eines Gebers, z.B. dem der Nokkenwelle zugeordneten Geberrad durchführen. Unter Zuhilfenahme der Methode des redundanten Starts kann z.B. durch Einspritzung von Kraftstoff in einen der Zylinder der Verbrennungskraftmaschine ein Betrieb der Verbrennungskraftmaschine aufrechterhalten werden, bis durch Erkennung eines Drehzahlgradienten eine Positionsbestimmung der Verbrennungskraftmaschine möglich ist.

Die Nockenwellen von Verbrennungskraftmaschinen zugeordneten Geberräder lassen sich einfach ausbilden, so daß deren kostengünstige Herstellung möglich ist. Die Entwicklung eines neuen Sensors kann somit umgangen werden. Die bisher eingesetzten Steuerungsroutinen zum Schnellstart einer Verbrennungskraftmaschine können unverändert weiter benutzt werden, ohne daß Modifikationen an diesen erforderlich wären. Die vorgeschlagene Vorgehensweise ermöglicht eine einfache Synchronisation einer Verbrennungskraftmaschine unter Zuhilfenahme der einzelnen SYNC-Zähne der Zylinder. Durch Ermittlung der SYNC-Zähne der einzelnen Zylinder ist die eindeutige Ermittlung des zugehörigen Zylinders jeweils möglich. Die Ermittlung des zugehörigen Zylinders kann entweder aus dem Abstand zum Segmentzahn ermittelt werden, oder durch den Abstand zur Lücke des Kurbelwellengeberrades. Demgegenüber wäre nur unter Zuhilfenahme der SEG.-Zähne (d. h. der Segmentzähne) der einzelnen Zylinder eine eindeutige Positionsbestimmung nicht gegeben.

Anstelle dieser Information wird die Methode des redundanten Starts einer Verbrennungskraftmaschine herangezogen, solange bis durch Ausbildung eines Drehzahlgradienten eine Positionsbestimmung der Verbrennungskraftmaschine möglich ist.

Am Eingang des Steuergerätes der Verbrennungskraftmaschine kann ein konfigurierbarer Eingang ausgebildet werden, der sowohl auf eine steigende als auch auf eine fallende Flanke eines Nockenwellensensors reagieren kann.

### Zeichnung

Anhand der Zeichnung wird die Erfindung nachstehend eingehender beschrieben.

Es zeigt:
- Figur 1: die Verwertung steigender und fallender Flanken eines Nockenwellensensorsignals für ein Schnellstart der Verbrennungskraftmaschine und
- Figur 2: die Auswertung lediglich einer Flanke des Nockenwellensensorsignals und
- Figur 3: die Auswertung steigender und fallender Flanken eines Nockenwellensensorsignals.

### Ausführungsvarianten

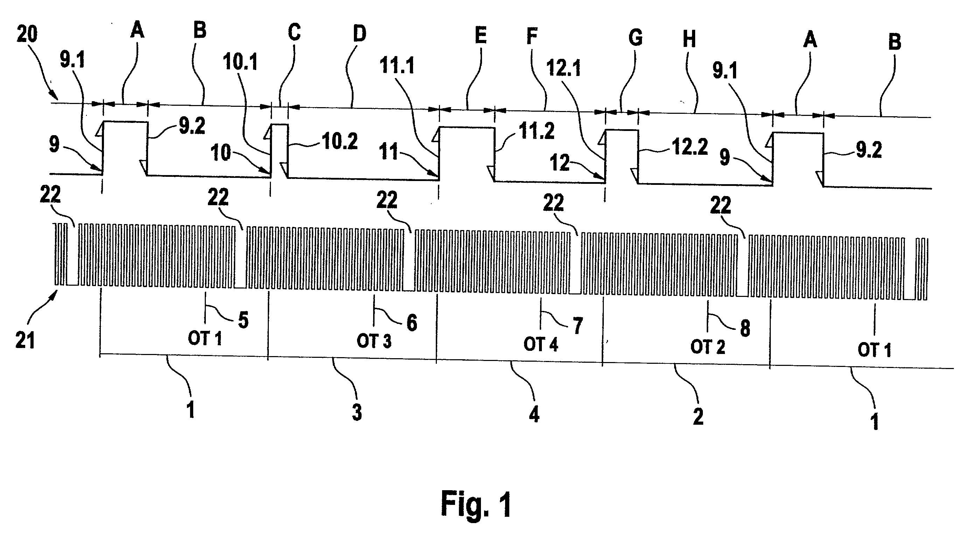

Figur 1 zeigt die Verläufe steigender und fallender Flanken von Signalpulsen, die Segmentzähne des Nockenwellengebers bei einzelnen Zylinder einer Verbrennungskraftmaschine repräsentieren.

Es sind der Verlauf 20 eines Nockenwellensignalpulses und der Verlauf 21 eines Inkrementsignals eines Kurbelwellensensors übereinanderliegend für vier Zylinder 1, 2, 3, 4 einer 4-Zylinderverbrennungskraftmaschine aufgetragen. Die Verläufe des Nockenwellengebersignales 20 und des Signals 21 des Kurbelwellendrehlagegebers für 3, 5, 6- bzw. 8-10 oder 12 Zylinderverbrennungskraftmaschinen verliefen analog bis auf den Umstand, daß eine größere/kleinere Zylinderzahl zu berücksichtigen wäre sowie Impulssegmente im Nockenwellensignalpulsverlauf 20 andere Pulslängen aufwiesen.

Gemäß der Darstellung in Figur 1 wird ein dem Zylinder 1 zugeordnete Segmentzahn 9 durch ein Impulssegment A des Signalpulsverlaufes 20 wiedergegeben. Die Länge des Impulssegmentes A wird durch die Position seiner steigenden Flanke 9.1 bzw. seiner fallenden Flanke 9.2 bestimmt. An die fallende Flanke 9.2 des Impulssegmentes A schließt sich ein Impulssegment B an, welches sich bis zu einer steigenden Flanke 10.1 eines Segmentzahnes 10 des Zylinders 3 erstreckt.

Der Segmentzahn 10 ist durch ein Impulssegment C charakterisiert, dessen Länge wesentlich geringer als die des Impulssegmentes A ist, welche den Segmentzahn 9 des Zylinders 1 der Verbrennungskraftmaschine repräsentiert.

An die fallende Flanke 10.2 des Segmentzahns 10 für Zylinder 3 schließt sich ein Impulssegment D an, das sich bis zur steigenden Flanke 11.1 eines Segmentzahnes 11 des Zylinders 4 der Verbrennungskraftmaschine erstreckt. Die Länge des Impulssegmentes E des Segmentzahnes 11 für den Zylinder 4 der Verbrennungskraftmaschine ist wiederum größer bemessen als die Impulslänge des Segmentzahns 10 für Zylinder 3 und auch größer bemessen als das Impulssegment A des Segmentzahnes 9 des Zylinders 1 der Verbrennungskraftmaschine. An die fallende Flanke 11.2 des Segmentzahns 11 schließt sich ein Impulssegment F an, welches sich bis zu einer steigenden Flanke 12.1 des Segmentzahns 10 für den Zylinder 2 der Verbrennungskraftmaschine erstreckt. Der Segmentzahn 12 für Zylinder 2 der Verbrennungskraftmaschine ist durch das Impulssegment G charakterisiert, welches kürzer als die Impulssegmente A und E über die Zylinder 1 und 4 der Verbrennungskraftmaschine bemessen ist, jedoch länger bemessen ist als das Impulssegment C des Segmentzahns 10 des Zylinders 3 der Verbrennungskraftmaschine.

An die fallende Flanke 12.2 des Segmentzahnes 12 für den Zylinder 2 der Verbrennungskraftmaschine schließt sich das Impulssegment H an, welches sich bis zur steigenden Flanke 9.1 des Segmentzahns 9 für den Zylinder 1 der Verbrennungskraftmaschine erstreckt. Danach erfolgt ein erneuter, dem dargestellten Signalpulsverlauf 20 entsprechender Durchlauf der einzelnen Segmentzähne 9, 10, 11 und 12 am Nockenwellengeberrad der Nockenwelle.

Parallel zum Verlauf 20 des Signalpulses der Nockenwelle ist in Figur 1 der Verlauf 21 des Signals eines Inkrementalgebers aufgetragen. An Kurbelwellen von Verbrennungskraftmaschinen werden bevorzugt Kurbelwellendrehlagegeberräder eingesetzt, die in 60-2 Ausführunge oder 60-2 x 2 Ausführung oder in 60-2 x 3 Ausführung beschaffen sind. Dadurch entsteht bei Passage der Zahnlücke am Umfang des Kur-belwellendrehlagegeberrades eine Signallücke, die in der Darstellung gemäß Figur 1 mit Bezugszeichen 22 gekennzeichnet ist. Der obere Totpunkt des Zylinders 1 ist mit Bezugs-zeichen 5 gekennzeichnet, der obere Totpunkt des Zylinders 3 mit Bezugszeichen 6, derjenige des Zylinders 4 mit Bezugszeichen 7 und derjenige des Zylinders 2 der Verbrennungskraftmaschine mit Bezugszeichen 8.

Beim Normalbetrieb einer Verbrennungskraftmaschine mit intakten Kurbelwellendrehlagegeberrad und Sensor und intaktem Nockenwellengeberrad und zugehörigem Sensor, werden die Signalverläufe 20 bzw. 21 parallel aufgenommen. Im Normalbetrieb werden sowohl die steigenden Flanken 9.1, 10.1, 11.1 und 12.2 der Segmentzähne 9, 10, 11 und 12 als auch deren jeweilige fallenden Flanken 9.2, 10.2, 11.2 sowie 12.2 zur Umsetzung eines Schnellstartes verwendet.

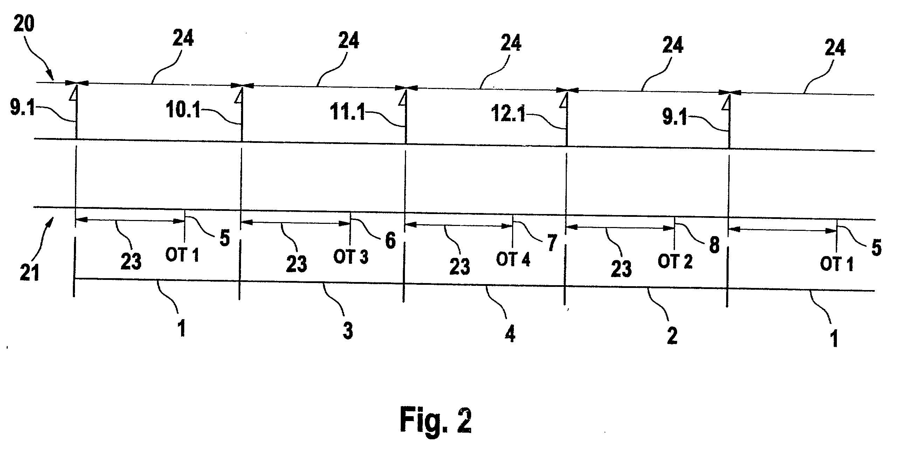

Figur 2 zeigt die Auswertung lediglich einer Flanke des Nockenwellensignalpulses an einem Steuergerät einer Verbrennungskraftmaschine.

Gemäß der in Figur 2 wiedergegebenen Darstellung liefert der Kurbelwellensensor kein Signal und ist als dauerhaft gestört oder defekt erkannt worden. An mindestens einem konfigurierbaren Steuergeräteeingang des Steuergerätes der Verbrennungskraftmaschine kann dieser sowohl auf eine steigende Flanke 9.1, 10.1, 11.1 oder 12.1 des Signals des Nockenwellensensors als auch auf eine fallende Flanke 9.2, 10.2, 11.2 bzw. 12.2 des Nockenwellensensorsignals reagieren. In der Darstellung gemäß Figur 2 sind repräsentativ die weiteren Flanken 9.1, 10.1, 11.1 bzw. 12.1 des Nockenwellensensorsignals dargestellt. Gemäß des Nockenwellensignalverlaufes 20 stellen sich zwischen den einzelnen steigenden Flanken 9.1, 10.1, 11.1, 12.1 der Segmentzähne 9, 10, 11 und 12 der Zylinder 1, 2, 3, 4 der Verbrennungskraftmaschine identische Abstände 24 ein. Zu diesen Abständen 24 einzelner steigender Flanken 9.1, 10.1, 11.1 und 12.1 der Segmentzähne 9, 10, 11 und 12 korrespondierend, erreichen die jeweiligen Zylinder 1, 3, 4 und 2 gemäß der Darstellung in Figur 2 ihren jeweiligen oberen Totpunkt 5, 6, 7 oder 8 nach einem wohl definierten Kurbelwellenumdrehungsabschnitt 23, der durch die Kröpfung der Kurbelwelle fest vorgegeben ist.

Am Steuergerät, dessen mindestens ein konfigurierbarer Steuergeräteeingang gemäß der Darstellung in Figur 2 auf die Erkennung der steigenden Flanken 9.1, 10.1, 11.1 bzw. 12.1 der Segmentzähne 9, 10, 11 und 12 geschaltet ist, werden die steigenden Flanken 9.1, 10.1, 11.1 und 12.1 der Segmentzähne 9, 10, 11 und 12 in konstanten Abständen 24 aufeinanderfolgend erkannt. Die zeitlichen Abstände 24 der einzelnen steigenden Flanken 9.1, 10.1, 11.1 und 12.1 bleiben solange konstant, wie sich die Drehzahl der Verbrennungskraftmaschine nicht ändert. Eine Drehzahländerung der Verbrennungskraftmaschine wird zu einer Verkürzung der zeitlichen Abstände 24 zwischen der Abfolge der einzelnen steigenden Flanken 9.1, 10.1, 11.1 bzw. 12.1 am konfigurierbaren Steuergeräteeingang des Steuergerätes führen. Ein Drehzahlgradient stellt sich beispielsweise dann ein, wenn die Verbrennungskraftmaschine gemäß der Methode des redundanten Starts derart betrieben wird, daß in einen Zylinder einer Kraftstoffeinspritzung vorgenommen wird, bis sich ein detektierbarer Drehzahlgradient einstellt. Aus dem ermittelten Drehzahlgradienten kann eine Positionsbestimmung, d.h. eine Drehlagebestimmung der Verbrennungskraftmaschine bei ausgefallenem Kurbelwellensensor lediglich aus der durch die Nockenwelle aufgenommenen Drehlage abgeleitet werden.

Anstelle der in Figur 2 dargestellten Erfassung jeweils der steigenden Flanken 9.1, 10.1, 11.1 bzw. 12.1 der jeweiligen Segmentzähne 9, 10, 11 und 12 der Zylinder 1, 2, 3, 4 der Verbrennungskraftmaschine, kann der konfigurierbare Steuergeräteeingang auch auf die Auswertung der jeweils fallenden Flanken 9.2, 10.2, 11.2 bzw. 12.2 der einzelnen Segmentzähne 9, 10, 11 und 12 konfiguriert werden.

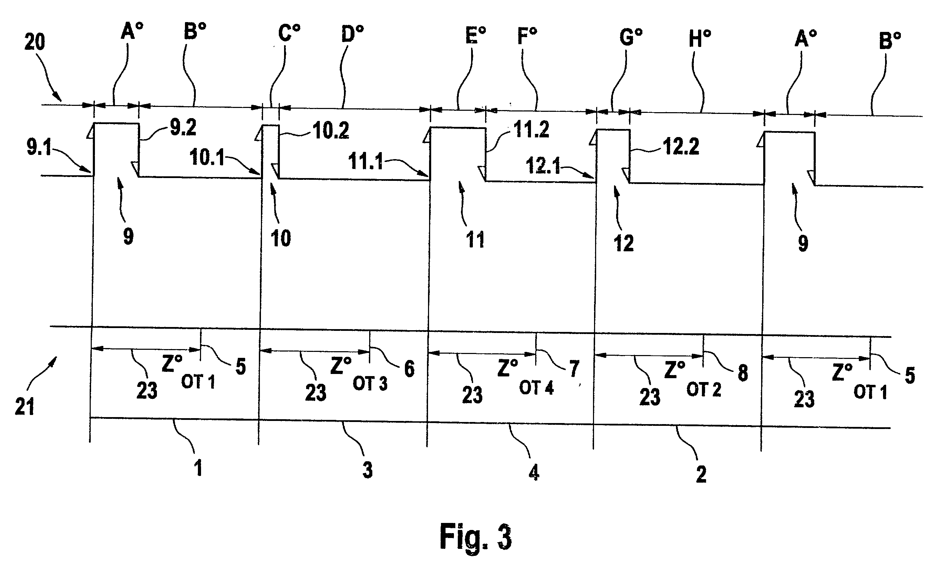

Der Darstellung gemäß Figur 3 ist die Auswertung steigender und fallender Flanken des Nockenwellensensorsignales zur Verbesserung der Zumeßgenauigkeit zu entnehmen.

Gemäß der Darstellung in Figur 3 werden am Steuergerät mindestens einem konfigurierbaren Steuergeräteeingang sowohl die steigenden Flanken 9.1, 10.1, 11.1 bzw. 12.1 der Segmentzähne 9, 10, 11 und 12 erfaßt als auch deren fallende Flanken 9.2, 10.2, 11.2 bzw. 12.2. Durch die unterschiedliche Impulssegmentlänge der Pulsabschnitte A, C, E und G, welche die Segmentzähne 9, 10, 11 und 12 der Zylinder 1, 3, 4 und 2 der Verbrennungskraftmaschine repräsentieren, lassen sich durch die Nockenwellensegmentzeiten aller Segmente A, B, C, D, E, F, G und H Berechnungen zur Motordynamik vornehmen. Mittels der erfaßten Segmentzeiten A, B, C, D, E, F, G und H ist eine Korrektur des Einspritzzeitpunktes des Kraftstoffs in die Brennräume der Verbrennungskraftmaschine sowie eine genaue Bestimmung der Einspritzdauer möglich. Durch die jeweils unterschiedlichen Segmentzeiten aller Segmente über einen kompletten Arbeitstakt, d.h. 720° Kurbelwellenwinkel und der sich dadurch ergebenden unterschiedlichen Positionen der fallenden Flanken 9.2, 10.2, 11.2 bzw. 12.2 der Segmentzähne 9, 10, 11 und 12 ist der Rechenaufwand zur Ermittlung der Motordynamik entsprechend aufwendiger.

### Bezugszeichenliste

- 1: Zylinder 1
- 2: Zylinder 2
- 3: Zylinder 3
- 4: Zylinder 4
- 5: OT-Zylinder 1
- 6: OT-Zylinder 3
- 7: OT-Zylinder 4
- 8: OT-Zylinder 2
- 9: Segmentzahn Zylinder 1
- 9.1: Steigende Flanke
- 9.2: Fallende Flanke
- 10: Segmentzahn Zylinder 3
- 10.1: Steigende Flanke
- 10.2: Fallende Flanke
- 11: Segmentzahn Zylinder 4
- 11.1: Steigende Flanke
- 11.2: Fallende Flanke
- 12: Segmentzahn Zylinder 2
- 12.1: Steigende Flanke
- 12.2: Fallende Flanke
- A: Impulssegment
- B: Impulssegment
- C: Impulssegment
- D: Impulssegment
- E: Impulssegment
- F: Impulssegment
- G: Impulssegment
- H: Impulssegment
- 20: Signalpulsverlauf Nockenwellensensor
- 21: Signalverlauf Inkrementalgeber Kurbelwellen
- 22: Impulslücke
- 23: Kurbelwellendrehung pro Zylinder
- 24: Nockenwellendrehung pro Zylinder

## Patentansprüche

1. Verfahren zur Drehlagebestimmung einer Verbrennungskraftmaschine mit einer Nokkenwelle, der ein Nockenwellensensor zugeordnet ist und die mit einem Nockenwellengeberrad versehen ist sowie einem Steuergerät, welches zumindest einen konfigurierbaren Steuergeräteeingang umfaßt, mit nachfolgenden Verfahrensschritten:
• nach Erkennen einer Fehlfunktion des Kurbelwellendrehlagegebers wird der mindestens eine Steuergeräteeingang auf die Auswertung einer der Flanken (9.1, 10.1, 11.1, 12.2; 9.2, 10.2, 11.2 bzw. 12.2) oder aller Flanken (9.1 bis 12.1, 9.2 bis 12.2) von Impulssegmenten (A, C, E, G) geschaltet,
• es erfolgen Einspritzungen von Kraftstoff in Zylinder der Verbrennungskraftmaschine bis ein sich einstellender Drehzahlgradient erkannt wird.

2. Verfahren gemäß Anspruch 1, **dadurch gekennzeichnet, daß** der Steuergeräteeingang auf die Auswertung der steigenden Flanken (9.1, 10.1, 11.1, 12.1) von Impulssegmenten (A, C, E, G) geschaltet wird.

3. Verfahren gemäß Anspruch 1, **dadurch gekennzeichnet, daß** der konfigurierbare Steuergeräteeingang auf die Auswertung der fallenden Flanken (9.2, 10.2, 11.2., 12.2) von Impulssegmenten (A, C, E, G) geschaltet wird.

4. Verfahren gemäß Anspruch 1, **dadurch gekennzeichnet, daß** die Impulssegmente (A, C, E, G) des Nockenwellensignalpulses (20) voneinander verschiedene Nockenwellenwinkelbereiche abdecken.

5. Verfahren gemäß Anspruch 1, **dadurch gekennzeichnet, daß** der Abstand (24) der steigenden Flanken (9.1, 10.1, 11.1 und 12.2) des Nockenwellensignalpulses der Impulssegmente (A, C, E, G) zu OT identisch ist.

6. Verfahren gemäß Anspruch 1, **dadurch gekennzeichnet, daß** aus einem Vergleich der Abstände (24) steigender oder fallender Flanken (9.1, 10.1, 11.1, 12.1; 9.2, 10.2, 11.2, 12.2) von Impulssegmenten (A, C, E, G) am konfigurierbaren Steuergeräteeingang ein Drehzahlgradient ermittelt wird.

7. Verfahren gemäß Anspruch 1, **dadurch gekennzeichnet, daß** nach erfolgter Positionsbestimmung der Kurbelwellenwinkellage der Verbrennungskraftmaschine zur Verbesserung der Zumessung von Kraftstoff in die Brennräume der Verbrennungskraftmaschine am Steuergerät konfigurierbare Steuergeräteeingänge auf steigende Flanken (9.1, 10.1., 11.1, 12.1) sowie fallende Flanken (9.2, 10.2, 11.2 und 12.2) von Impulssegmenten (A, C, E, G) umgeschaltet werden.

8. Verfahren gemäß Anspruch 7, **dadurch gekennzeichnet, daß** aus den erfaßten Nockenwellensegmentzeiten der Impulssegmente (A, B, C, D, E, F, G, H) die Motordynamik berechnet wird und anhand der Impulssegmentzeiten (A, B, C, D, E, F, G, H) eine Korrektur des Einspritzzeitpunktes erfolgt.

9. Verfahren gemäß Anspruch 8, **dadurch gekennzeichnet, daß** aus den am Steuergerät mit mindestens einem konfigurierbaren Steuergeräteeingang zur Verfügung stehenden Nockenwellenzeitsegmenten der Impulssegmente (A, B, C, D, E, F, G, H) eine Korrektur der Einspritzdauer von Kraftstoffeinspritzungen in die Verbrennungskraftmaschine erfolgt.
